# FASCICULE DE BREVET EUROPEEN

(11) **EP 3 117 020 B1**
(45) Date de publication et mention de la délivrance du brevet: **22.11.2017**
(21) Numéro de dépôt: 15713984.1
(22) Date de dépôt: 05.03.2015
(51) Int. Cl.: C23C 16/04, C23C 16/455, C04B 35/00, C04B 35/83, C23C 16/452, F27B 5/16, F27D 7/06, F27D 99/00, F28F 3/08, F28F 13/06, F28F 9/02, F28D 9/00

(54) **INSTALLATION DE DENSIFICATION CVI COMPRENANT UNE ZONE DE PRECHAUFFAGE A FORTE CAPACITE.**
CVI-VERDICHTUNGSAUSRÜSTUNG MIT HOCHKAPAZITIVEM VORWÄRMBEREICH
CVI DENSIFICATION EQUIPMENT INCLUDING A HIGH-CAPABILITY PREHEATING AREA

(30) Priorité: 14.03.2014 FR 1452151
(43) Date de publication de la demande: 18.01.2017
(73) Titulaire: Safran Ceramics, 33185 Le Haillan (FR)
(72) Inventeur: DELPERIER, Bernard, F-33700 Merignac (FR); POTIN, Jean-François, F-33700 Merignac (FR); SOULIGNAC, Sophie, F-33290Le Pian Medoc (FR)
(74) Mandataire: Desormiere, Pierre-Louis
(86) Numéro de dépôt international: PCT/FR2015/050546
(87) Numéro de publication internationale: WO 2015/136193

(56) Documents cités:
- US-A- 5 362 228
- US-A- 5 480 678

## Description

### Arrière-plan de l'invention

L'invention concerne les installations ou fours utilisés pour réaliser des traitements thermiques et dans lesquels le ou les gaz utilisés dans les traitements sont préchauffés avant leur introduction dans la chambre de traitement de l'installation. De telles installations sont notamment utilisées pour réaliser des traitements thermochimiques comme la cémentation de pièces ou la densification de substrats poreux par infiltration chimique en phase gazeuse.

Un domaine d'application de l'invention est celui de la réalisation de pièces en matériau composite thermostructural, c'est-à-dire en matériau composite ayant à la fois des propriétés mécaniques qui le rendent apte à constituer des pièces structurelles et la capacité de conserver ces propriétés jusqu'à des températures élevées. Des exemples typiques de matériaux composites thermostructuraux sont les composites carbone/carbone (C/C) ayant une texture de renfort en fibres de carbone densifiée par une matrice de carbone pyrolytique et les composites à matrice céramique (CMC) ayant une texture de renfort en fibres réfractaires (carbone ou céramique) densifiée par une matrice céramique.

Un processus bien connu de densification de substrats poreux pour réaliser des pièces en composite C/C ou en CMC est l'infiltration chimique en phase gazeuse (CVI). Les substrats à densifier sont placés dans une zone de chargement d'une installation où ils sont chauffés. Un gaz réactif contenant un ou plusieurs précurseurs gazeux du matériau constitutif de la matrice est introduit dans le four. La température et la pression dans l'installation sont réglées pour permettre au gaz réactif de diffuser au sein de la porosité des substrats et y former un dépôt du matériau constitutif de la matrice par décomposition d'un ou plusieurs constituants du gaz réactif ou réaction entre plusieurs constituants, ces constituants formant le précurseur de la matrice. Le processus est réalisé sous pression réduite, afin de favoriser la diffusion des gaz réactifs dans les substrats. La température de transformation du ou des précurseurs pour former le matériau de la matrice, tel que carbone pyrolytique ou céramique, est dans la plupart des cas comprise entre 900°C et 1100°C, cette température pouvant toutefois atteindre 2000°C dans le cas d'un dépôt massif de carbone pyrolytique par dépôt chimique en phase gazeuse (CVD)

Afin de réaliser une densification la plus homogène possible des substrats dans toute la zone de chargement, que ce soit en terme d'accroissement de densité ou en terme de microstructure du matériau de matrice formé, il est nécessaire que le gaz réactif pénètre dans la zone de chargement avec une température minimale et homogène.

Aussi, les installations comportent habituellement des moyens de préchauffage du gaz. Ces moyens de préchauffage peuvent être situés en périphérie de l'installation, c'est-à-dire sur le trajet du gaz avant son entrée dans l'enceinte de traitement de l'installation. De tels moyens de préchauffage augmentent la complexité et l'encombrement de l'installation.

Afin d'éviter ces inconvénients, il est connu de doter l'installation d'une zone ou chambre de préchauffage de gaz réactif située entre l'entrée du gaz réactif dans l'installation et la zone de chargement. Typiquement, la zone de préchauffage comprend une pluralité de plateaux perforés parcourus par le gaz réactif.

Les plateaux de préchauffage du gaz, de même que les substrats sont chauffés du fait de leur présence dans l'installation. Le chauffage de l'installation est généralement assuré par induction ou par des moyens électriques tels que des résistances logées dans la paroi de l'installation.

Cependant, si la chambre de préchauffage permet de chauffer le gaz réactif avant son introduction dans la zone de chargement, il est difficile de contrôler radialement l'homogénéité de la température du gaz réactif dans la chambre de préchauffage, en particulier dans des installations de grand diamètre.

Afin de résoudre ce problème, il pourrait être envisagé d'accroître l'efficacité du préchauffage du gaz par agrandissement de la zone de préchauffage notamment par augmentation de son volume en hauteur mais au détriment de celui de la zone chargement à volume total d'installation égal. Or, les traitements tels que les processus d'infiltration chimique en phase gazeuse demandent des investissements coûteux à l'échelle industrielle, et sont très longs à réaliser. Il est donc hautement souhaitable que les installations aient une productivité élevée, que ce soient des installations en service ou de nouvelles installations à réaliser, donc un rapport aussi élevé que possible entre volume utile dédié au chargement des substrats ou pièces à traiter et volume dédié au chauffage du gaz réactif.

Le document US 5 362 228 divulgue un dispositif de préchauffage pour une installation de densification par infiltration chimique en phase vapeur.

### Objet et résumé de l'invention

L'invention a pour but de proposer une conception d'installation de traitement thermochimique qui permet de préchauffer un flux gazeux à une température déterminée tout en minimisant les écarts de température entre le centre et la périphérie de l'installation en sortie de la chambre de préchauffage, et ce sans avoir à augmenter son volume de manière à privilégier la productivité de l'installation.

A cet effet, la présente invention propose une installation de traitement thermochimique comprenant une chambre de réaction, au moins une entrée de gaz, une chambre de préchauffage de gaz située entre l'entrée de gaz et la chambre de réaction, ladite chambre de préchauffage comprenant plusieurs plateaux de distribution perforés maintenus de manière espacée les uns au-dessus des autres, caractérisée en ce que la chambre de préchauffage comprend en outre, entre au moins deux plateaux de distribution en vis-à-vis, une pluralité de parois définissant entre lesdits plateaux des chemins de circulation pour un flux gazeux, chaque paroi s'entendant verticalement entre lesdits au moins deux plateaux de distribution en vis-à-vis.

En utilisant des parois entre les plateaux de distribution, on augmente la capacité de chauffage de la chambre de préchauffage en accroissant les échanges de chaleur par convexion, d'une part, et, d'autre part, en rallongeant le parcours et, par conséquent, le temps de séjour du gaz dans la chambre de préchauffage. On améliore aussi l'homogénéité du profil de température du gaz réactif en sortie de chambre de préchauffage, et ce quel que soit le diamètre de l'installation. Avec l'installation de l'invention, il est possible d'obtenir des performances de préchauffage équivalentes, voire meilleures, et ce avec une chambre de préchauffage présentant un volume inférieur à celui d'une chambre ne comprenant pas de parois. Alternativement, à volume de chambre de préchauffage égal, on obtient des performances de température et d'homogénéité de chauffe bien supérieures avec une chambre de préchauffage munie de parois selon l'invention qu'avec une chambre de préchauffage ne comprenant pas de telles parois.

Selon une caractéristique de l'installation de l'invention, les plateaux de distribution présentent une forme de disque et au moins certaines parois s'étendent entre lesdits plateaux suivant une direction radiale. Une telle disposition permet de guider l'écoulement du flux gazeux sur l'ensemble de la surface des plateaux et de maximiser le transfert de chaleur.

Selon une autre caractéristique de l'installation de l'invention, au moins une partie des parois présente une forme ondulée, ce qui permet de rallonger la longueur des parois et, par conséquent, la surface d'échange thermique pour le flux gazeux.

Selon une autre caractéristique de l'installation de l'invention, les parois présentent une conductivité thermique plus importante dans une direction parallèle aux plateaux de distribution que dans une direction perpendiculaire auxdits plateaux perforés. Cela permet de définir une conduction thermique anisotrope entre les plateaux de distribution qui crée un découplage thermique partiel entre la partie froide de l'installation et la zone de chargement tout en augmentant la capacité de chauffage de la chambre de préchauffage. Dans ce cas, les parois peuvent être en matériau composite comprenant un renfort fibreux densifié par une matrice, avec les fibres du renfort qui sont majoritairement orientées dans une direction parallèle aux plateaux de distribution ou en graphite.

Selon une autre caractéristique de l'installation de l'invention, le nombre de parois est plus important au voisinage de la périphérie des plateaux de distribution qu'au centre desdits plateaux. On optimise ainsi la distribution des parois entre les plateaux et on augmente encore la surface d'échange thermique pour le flux gazeux.

Selon une autre caractéristique de l'installation de l'invention, celle-ci comprend un plateau de chargement présent au-dessus des plateaux de distribution de la chambre de préchauffage, ledit plateau de chargement étant supporté par des colonnes traversant les plateaux de distribution. On réalise ainsi un découplage entre les fonctions mécanique et thermique dans la chambre de préchauffage.

### Brève description des dessins

D'autres particularités et avantages du four de densification conforme à l'invention ressortiront à la lecture de la description faite ci-après, à titre indicatif mais non limitatif, en référence aux dessins annexés sur lesquels :
- la figure 1 est une vue schématique en coupe d'une installation de densification par infiltration chimique en phase gazeuse conformément à un mode de réalisation de l'invention;
- la figure 2 est une vue éclatée en perspective montrant les éléments constitutifs de la chambre de préchauffage de l'installation de la figure 1;
- la figure 3 est une vue de dessus d'un plateau de distribution de la chambre de préchauffage de la figure 2;
- la figure 4 est une vue éclatée en perspective montrant les éléments constitutifs d'une chambre de préchauffage conformément à un autre mode de réalisation de l'invention;
- la figure 5 est une vue de dessus d'un plateau de distribution de la chambre de préchauffage de la figure 4.

### Description détaillée de modes de réalisation

L'invention s'applique à tout type d'installations ou fours utilisés pour réaliser des traitements thermiques et dans lesquels le ou les gaz utilisés dans les traitements sont préchauffés dans une chambre de préchauffage avant leur introduction dans la zone de traitement ou de chargement de l'installation. De telles installations sont notamment utilisées pour réaliser des traitements thermochimiques comme la cémentation de pièces ou la densification de substrats poreux par infiltration chimique en phase gazeuse.

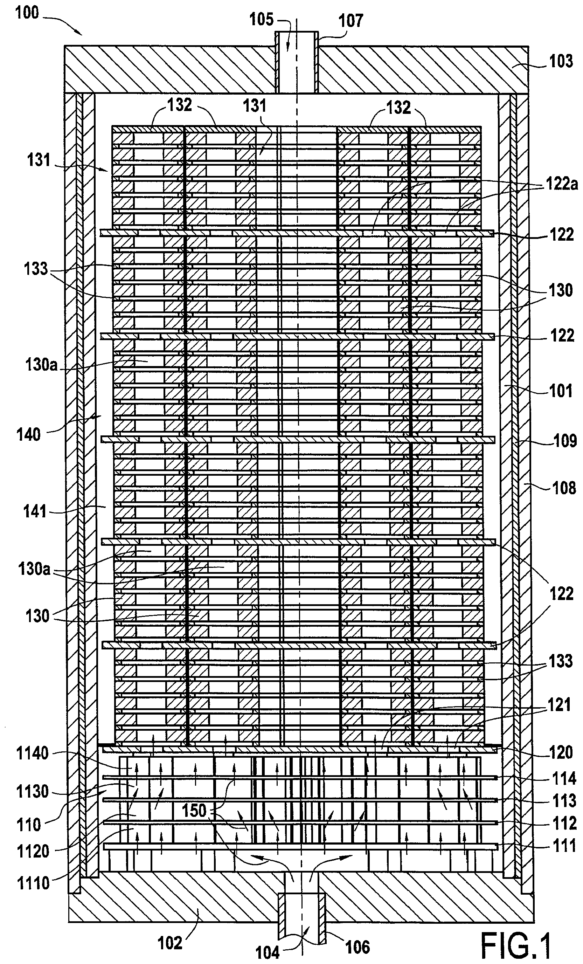

Un premier mode de réalisation d'un four de densification est décrit en relation avec les figures 1 à 3. La figure 1 montre schématiquement une installation de densification par infiltration chimique en phase gazeuse 100 délimitée par une paroi latérale cylindrique 101, une paroi de fond 102 et une paroi supérieure 103.

Une chambre de préchauffage de gaz 110, dont la structure sera décrite ci-après en détails, s'étend entre le fond 102 du four et un plateau de chargement 120. Une conduite 106 relie l'entrée de gaz réactif(s) 104 à la chambre de préchauffage 110, à travers le fond 102.

Des substrats à densifier 130 sont disposés dans une zone de chargement ou chambre de réaction 140 en une pluralité de piles verticales annulaires 131 qui reposent sur le plateau de chargement 120. Celui-ci comprend une pluralité de passages 121 alignés avec les volumes internes 130a des piles et chaque pile est obturée à sa partie supérieure par un couvercle 132. Les piles 131 de substrats 130 reposent sur le plateau de chargement 120 et peuvent être divisées en plusieurs sections superposées séparées par un ou plusieurs plateaux intermédiaires 122 ayant des passages centraux 122a alignés avec ceux des substrats 130. Chaque substrat 130 est séparé d'un substrat adjacent ou, le cas échéant, d'un plateau 120, 122 ou du couvercle 132 par des cales d'espacement 133 qui définissent des intervalles. Les cales 133, ou au moins une partie d'entre elles, sont aménagées pour ménager des passages pour le gaz entre les volumes 130a et 141. Ces passages peuvent être réalisés de manière à équilibrer sensiblement la pression entre les volumes 130a et 141, comme décrit dans le brevet US 5 904 957, ou de manière à constituer de simples passages de fuite maintenant un gradient de pression entre les volumes 130a et 141, comme décrit dans la demande de brevet EP 0 063 988.

Un flux gazeux 150, contenant un ou plusieurs précurseurs gazeux du matériau constitutif de la matrice, est admis dans le four à travers l'entrée 104 puis traverse la chambre de préchauffage 110. La phase gazeuse préchauffée est ensuite acheminée par les passages 121 du plateau de chargement 120 dans les volumes internes 130a des piles 131. Le gaz passe ensuite dans le volume 38 externe aux piles à l'intérieur de la chambre de réaction 140. Le gaz effluent est extrait par un passage 105 formé dans la paroi supérieure 103, le passage 105 étant relié par une conduite 107 à des moyens d'aspiration, tels qu'une pompe à vide (non représentée).

Selon une variante de réalisation, les volumes internes 130a peuvent être fermés au niveau de leur partie inférieure et mis en communication à sa partie supérieure avec le passage 105. Le flux gazeux provenant de la chambre de préchauffage 110 est alors admis dans le volume 141 de la chambre de réaction 140 et la circulation du gaz dans cette zone se fait du volume 141 vers les volumes 130a, le volume 141 étant obturé à sa partie supérieure.

Selon encore une autre variante, l'entrée du flux gazeux peut être réalisée à travers la paroi supérieure 103 de l'installation, la chambre de préchauffage étant alors située à la partie supérieure de l'installation, les volumes 130a étant en communication avec la chambre de préchauffage et obturés à leur partie inférieure tandis que le volume 141 communique avec une sortie de gaz formée dans la paroi inférieure du four, ou inversement.

Dans l'exemple décrit ici, le chauffage de l'installation est réalisé par induction. Plus précisément, la paroi latérale cylindrique 101 constitue un induit, ou suscepteur, par exemple en graphite, qui est couplé avec un inducteur 108 situé à l'extérieur du four et formé d'au moins une bobine d'induction. Un isolant 109 est interposé entre l'inducteur 108 et la paroi 101. De façon bien connue, le chauffage du four est assuré par l'échauffement de l'induit 101 lorsque l'inducteur 108 est alimenté avec une tension alternative. A cet effet, la ou les bobines de l'inducteur sont reliées à un générateur de tension alternative (non représenté).

Le champ magnétique créé par l'inducteur 108 induit dans la paroi 101 (suscepteur) un courant électrique qui provoque par effet Joule l'échauffement de cette dernière, les éléments présents à l'intérieur de la paroi 101 étant chauffés par rayonnement.

Le chauffage de l'installation 100 peut être assuré par d'autres moyens tels que des moyens de chauffage électriques constitués par exemple de résistances chauffantes noyées dans la paroi 101.

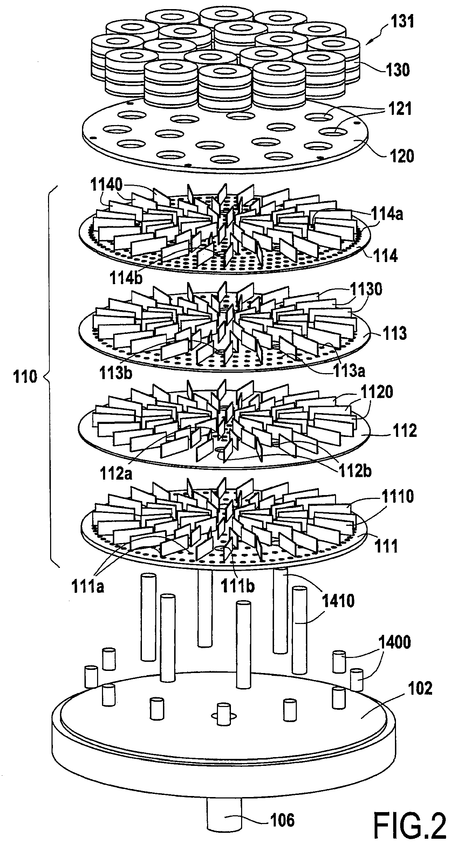

La chambre de préchauffage 110 comprend plusieurs plateaux de distribution, ici quatre plateaux 111, 112, 113 et 114 (figure 2). Chaque plateau de distribution 111, 112, 113 et 114 comporte respectivement une pluralité de perforations 111a, 112a, 113a et 114a à travers lesquelles le flux gazeux 150 va circuler lors de son préchauffage (figure 1).

Conformément à l'invention, des parois ou déflecteurs sont disposés dans les espaces présents entre les plateaux de distribution. Dans le mode de réalisation décrit ici :
- des parois 1110 sont disposées entre les plateaux de distribution 111 et 112, chaque paroi 1110 étant en contact à la fois avec les plateaux 111 et 112,
- des parois 1120 sont disposées entre les plateaux de distribution 112 et 113, chaque paroi 1120 étant en contact à la fois avec les plateaux 112 et 113,
- des parois 1130 sont disposées entre les plateaux de distribution 113 et 114, chaque paroi 1130 étant en contact à la fois avec les plateaux 113 et 114.

Par ailleurs, toujours dans le mode de réalisation décrit ici, des parois 1140 sont également disposées entre le plateau de distribution 114 et le plateau de chargement 120.

Selon des variantes de réalisation de l'invention, des parois ou déflecteurs peuvent être interposés entre seulement un nombre limité de plateau de distribution, voire seulement entre deux plateaux de distribution.

Dans le mode de réalisation présenté ici, les parois 1110, 1120, 1130 et 1140 présentent une forme plane et s'étendent verticalement entre les plateaux de distribution, les parois étant disposées perpendiculairement à la surface des plateaux en vis-à-vis. Les plateaux de distribution 112, 113 et 114 reposent respectivement sur les parois 1110, 1120 et 1130. Le plateau de distribution 111 est supporté par des entretoises 1400 qui s'étendent entre le fond 102 de l'installation 100 et la surface inférieure du plateau 111.

Le plateau de chargement 120, supportant l'ensemble des piles 131, est quant à lui supporté par des colonnes 1410 reposant sur le fond 102 de l'installation 100. Les colonnes 1410 traversent les plateaux de distribution via des ouvertures 111b, 112b, 113b et 114b ménagées respectivement dans les plateaux de distribution 111, 112, 113 et 114. On sépare ainsi au niveau de la chambre de préchauffage les fonctions mécanique et thermique, la fonction mécanique de support du chargement étant assurée par les colonnes 1410 tandis la fonction thermique est assurée par les plateaux de distribution 111, 112, 113 et 114 et les parois 1110, 1120, 1130 et 1140.

Les perforations 111a, 112a, 113a et 114a présentes respectivement dans les plateaux de distribution 111, 112, 113 et 114 sont de préférence positionnées à des endroits différents entre deux plateaux adjacents de manière à allonger le chemin de circulation de la phase gazeuse entre les plateaux de distribution. Sur la figure 2, les perforations 111a et 113a sont positionnées au voisinage de la périphérie des plateaux 111 et 113 tandis que les perforations 112a du plateau 112 interposé entre les plateaux 111 et 113 sont positionnées au voisinage du centre du plateau 112. Le plateau 114 qui est le dernier plateau de la chambre de préchauffage comporte des perforations 114a sur l'ensemble de sa surface.

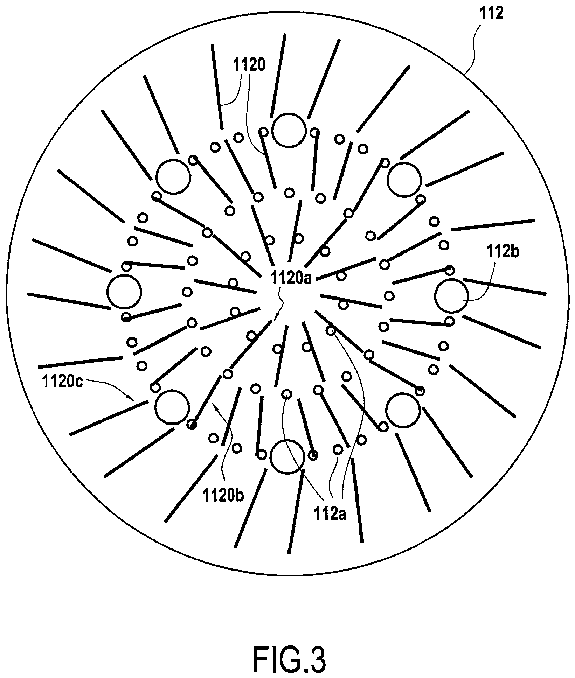

Comme illustrées sur la figure 3, les parois 1120 sont disposées sur le plateau 112 suivant une direction sensiblement radiale. Cette disposition radiale, qui est également celle des parois 1110, 1130 et 1140, permet de chauffer et guider le flux gazeux 150 débouchant dans l'espace présent entre deux plateaux de distribution. Sur la figure 3, les parois 1120 permettent de guider et chauffer le flux gazeux débouchant entre les plateaux de distribution 112 et 113 par les perforations 112a du plateau 112. Les parois 1110, 1120, 1130 et 1140 définissent ainsi entre respectivement les plateaux 111, 112, 113, 114 et 120 des chemins de circulation pour la phase gazeuse. Les parois 1110, 1120, 1130 et 1140 étant en un matériau apte à s'échauffer sous l'effet du rayonnement thermique de la paroi 101 de l'installation 100, elles permettent d'augmenter significativement la capacité de chauffage de la chambre de préchauffage en transférant de la chaleur par convection à la phase gazeuse et en optimisant l'écoulement de ladite phase gazeuse dans la chambre de préchauffage.

Par ailleurs, les parois présentent de préférences des dimensions inférieures au rayon des plateaux de distribution de manière à pouvoir occuper de façon optimale l'espace présent entre les plateaux de distribution. Sur la figure 3, les parois 1120 sont disposées radialement en trois séries, à savoir une première série 1120a au plus près de centre du plateau 112, une deuxième série 1120b au niveau d'une partie intermédiaire du plateau 112 et une troisième série 1120c au voisinage de la périphérie du plateau 112. Cette disposition est également celle des parois 1110, 1130 et 1140. Cette disposition radiale en plusieurs séries permet d'avoir un nombre de parois plus important à mesure que l'on s'éloigne du centre du plateau et d'optimiser ainsi la surface d'échange thermique constituée par les parois. En outre, cette disposition radiale en série des parois permet d'avoir des discontinuités dans les chemins de circulation du flux gazeux qui optimise son écoulement.

Les parois utilisées dans la chambre de préchauffage de l'invention sont réalisées avec des matériaux ayant une bonne capacité à transférer de la chaleur par convection comme par exemple du graphite ou un métal réfractaire tel que de l'inox ou du molybdène. Les parois sont en outre de préférence réalisées avec un matériau qui présente une conductivité thermique dans une direction parallèle aux plateaux de distribution qui est supérieure à la conductivité dans une direction perpendiculaire auxdits plateaux perforés. En effet, avec de tels matériaux, on définit une conduction thermique anisotrope entre les plateaux de distribution qui permet un découplage thermique partiel entre la partie froide de l'installation (paroi de fond ou paroi supérieure de l'installation en fonction de la position de la chambre de préchauffage) et la zone de chargement tout en augmentant la capacité de chauffage de la chambre de préchauffage. De tels matériaux peuvent être notamment du graphite ou un matériau composite thermostructural comprenant un renfort fibreux densifié par une matrice avec les fibres du renfort majoritairement orientées dans une direction parallèle aux plateaux de distribution.

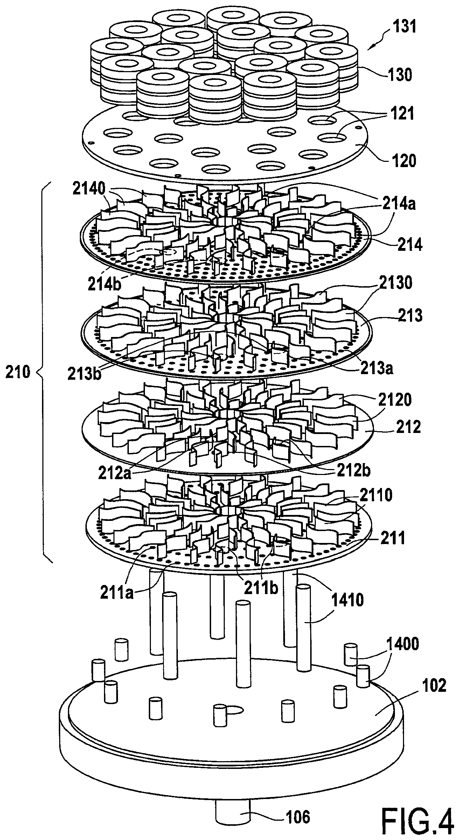

La figure 4 montre une chambre de préchauffage 210 qui diffère de la chambre de préchauffage 110 déjà décrite en ce qu'elle utilise des parois de forme ondulée. La chambre de préchauffage 210 s'intègre dans l'installation de densification par infiltration chimique 100 de la même manière que la chambre de préchauffage 110 déjà décrite. Par souci de simplification, les éléments de l'installation 100 déjà décrits ne seront pas décrits à nouveau.

La chambre de préchauffage 210 comprend plusieurs plateaux de distribution, ici quatre plateaux 211, 212, 213 et 214 comportant chacun respectivement une pluralité de perforations 211a, 212a, 213a et 214a à travers lesquelles la phase gazeuse va circuler lors de son préchauffage. Conformément à l'invention, des parois ou déflecteurs sont disposés dans les espaces présents entre les plateaux de distribution. Dans le mode de réalisation décrit ici :
- des parois 2110 sont disposées entre les plateaux de distribution 211 et 212, chaque paroi 2110 étant en contact à la fois avec les plateaux 211 et 212,
- des parois 2120 sont disposées entre les plateaux de distribution 212 et 213, chaque paroi 2120 étant en contact à la fois avec les plateaux 212 et 213,
- des parois 2130 sont disposées entre les plateaux de distribution 213 et 214, chaque paroi 2130 étant en contact à la fois avec les plateaux 213 et 214.

Par ailleurs, toujours dans le mode de réalisation décrit ici, des parois 2140 sont également disposées entre le plateau de distribution 214 et le plateau de chargement 220. Selon des variantes de réalisation de l'invention, des parois ou déflecteurs peuvent être interposés entre seulement un nombre limité de plateaux de distribution, voire seulement entre deux plateaux de distribution.

Dans le mode de réalisation présenté ici, les parois 2110, 2120, 2130 et 2140 présentent une forme ondulée et s'étendent verticalement entre les plateaux de distribution, les parois étant disposées perpendiculairement à la surface des plateaux en vis-à-vis. Cette forme ondulée des parois permet de rallonger la longueur des parois en comparaison avec des parois de forme plane comme les parois 1110, 1120, 1130 et 1140 décrites précédemment et d'augmenter, par conséquent, la surface d'échange thermique avec la phase gazeuse lors de son passage dans la chambre de préchauffage 210.

Les plateaux de distribution 212, 213 et 214 reposent respectivement sur les parois 2110, 2120 et 2130. Le plateau de distribution 211 est supporté par les entretoises 1400 qui s'étendent entre le fond 102 de l'installation 100 et la surface inférieure du plateau 111.

Le plateau de chargement 120, supportant l'ensemble des piles 131, est quant à lui supporté par des colonnes 1410 reposant sur le fond 102 de l'installation 100. Les colonnes 1410 traversent les plateaux de distribution via des ouvertures 211b, 212b, 213b et 214b ménagées respectivement dans les plateaux de distribution 211, 212, 213 et 214. On sépare ainsi au niveau de la chambre de préchauffage les fonctions mécanique et thermique, la fonction mécanique de support du chargement étant assurée par les colonnes 1410 tandis que la fonction thermique est assurée par les plateaux de distribution 211, 212, 213 et 214 et les parois 2110, 2120, 2130 et 2140.

Les perforations 211a, 212a, 213a et 214a présentes respectivement dans les plateaux de distribution 211, 212, 213 et 214 sont de préférence positionnées à des endroits différents entre deux plateaux adjacents de manière à allonger le chemin de circulation de la phase gazeuse entre les plateaux de distribution. Sur la figure 4, les perforations 211a, 212a, 213a et 214a sont positionnées respectivement de la même manière que les perforations 111a, 112a, 113a et 114a déjà décrites.

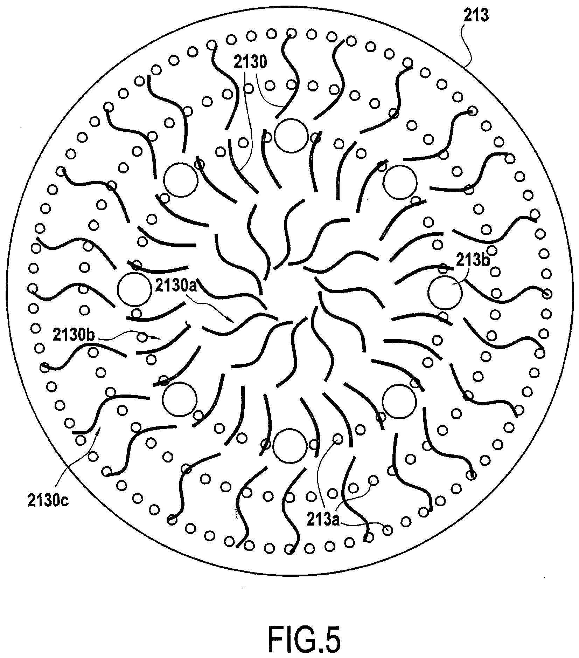

Comme illustrées sur la figure 5, les parois 2130 sont disposées sur le plateau 213 suivant une direction sensiblement radiale. Cette disposition radiale, qui est également celle des parois 2110, 2120 et 2140, permet de chauffer et guider le flux gazeux débouchant dans l'espace présent entre deux plateaux de distribution. Sur la figure 5, les parois 2130 permettent de guider et chauffer le flux gazeux débouchant entre les plateaux de distribution 213 et 214 par les perforations 213a du plateau 213.

Les parois présentent de préférences des dimensions inférieures au rayon des plateaux de distribution de manière à pouvoir occuper de façon optimale l'espace présent entre les plateaux de distribution. Sur la figure 5, les parois 2130 sont disposées radialement en trois séries, à savoir une première série 2110a au plus près de centre du plateau 213, une deuxième série 2130b au niveau d'une partie intermédiaire du plateau 213 et une troisième série 2130c au voisinage de la périphérie du plateau 213. Cette disposition radiale en plusieurs séries permet d'avoir un nombre de parois plus important à mesure que l'on s'éloigne du centre du plateau et d'optimiser ainsi la surface d'échange thermique constituée par les parois. En outre, cette disposition radiale en série des parois permet d'avoir des discontinuités dans les chemins de circulation de la phase gazeuse qui optimise son écoulement.

Les parois utilisées dans la chambre de préchauffage de l'invention sont réalisées avec des matériaux ayant une bonne capacité à transférer de la chaleur par convection comme par exemple du graphite ou un métal réfractaire tel que de l'inox ou du molybdène. Les parois sont en outre de préférence réalisées avec un matériau qui présente une conductivité thermique plus élevée dans une direction parallèle aux plateaux de distribution que dans une direction perpendiculaire auxdits plateaux perforés. En effet, avec de tels matériaux, on définit une conduction thermique anisotrope entre les plateaux de distribution qui permet un découplage thermique partiel entre la partie froide de l'installation (paroi de fond ou paroi supérieure de l'installation en fonction de la position d la chambre de préchauffage) et la zone de chargement tout en augmentant la capacité de chauffage de la chambre de préchauffage. De tels matériaux peuvent être notamment du graphite ou un matériau composite thermostructural comprenant un renfort fibreux densifié par une matrice avec les fibres du renfort majoritairement orientées dans une direction parallèle aux plateaux de distribution.

A titre d'exemple comparatif dans une installation de densification par infiltration chimique en phase vapeur, il a été possible de réduire de 30% la hauteur de la chambre de préchauffage en utilisant une zone de préchauffage conforme à l'invention, c'est-à-dire une zone de préchauffage comportant des parois entre les plateaux définissant des chemins de circulation pour le flux gazeux, et ce avec des performances égales voire supérieures en termes de capacité et d'homogénéité de chauffage du flux gazeux que celle de la chambre de préchauffage selon l'art antérieur, c'est-à-dire ne comportant pas de telles parois entre les plateaux. Cette diminution de hauteur de la chambre de préchauffage grâce à l'invention est autant de hauteur rendue à la zone utile de l'installation, à savoir la chambre de traitement dont la capacité de chargement est ainsi augmentée.

## Revendications

1. Installation de traitement thermochimique (100) comprenant une chambre de réaction (140), au moins une entrée de gaz (104), une chambre de préchauffage de gaz (110) située entre l'entrée de gaz (104) et la chambre de réaction (140), ladite chambre de préchauffage (110) comprenant plusieurs plateaux de distribution perforés (111-114) maintenus de manière espacée les uns au-dessus des autres,
**caractérisée en ce que** la chambre de préchauffage (110) comprend en outre, entre au moins deux plateaux de distribution en vis-à-vis, une pluralité de parois (1110, 1120, 1130, 1140) définissant entre lesdits plateaux (111-114) des chemins de circulation pour un flux gazeux, chaque paroi s'entendant verticalement entre lesdits au moins deux plateaux de distribution en vis-à-vis.

2. Installation selon la revendication 1, **caractérisée en ce que** les plateaux de distribution (111-114) présentent une forme de disque et **en ce qu'**au moins certaines parois (1110, 1120, 1130, 1140) s'étendent entre lesdits plateaux suivant une direction radiale.

3. Installation selon la revendication 1 ou 2, **caractérisée en ce qu'**au moins une partie des parois (2110, 2120, 2130, 2140) présente une forme ondulée.

4. Installation selon l'une quelconque des revendications 1 à 3, **caractérisée en ce que** les parois (1110, 1120, 1130, 1140) présentent une conductivité thermique supérieure dans une direction parallèle aux plateaux de distribution (111-114) que dans une direction perpendiculaire auxdits plateaux perforés.

5. Installation selon la revendication 4, **caractérisée en ce que** les parois (1110, 1120, 1130, 1140) sont en matériau composite comprenant un renfort fibreux densifié par une matrice et **en ce que** les fibres du renfort sont majoritairement orientées dans une direction parallèle aux plateaux de distribution (111-114).

6. Installation selon la revendication 4, **caractérisée en ce que** les parois (1110, 1120, 1130, 1140) sont en graphite.

7. Installation selon l'une quelconque des revendications 2 à 6, **caractérisée en ce que** le nombre de parois (1110, 1120, 1130, 1140) est plus important au voisinage de la périphérie des plateaux (111-114) de distribution qu'au centre desdits plateaux.

8. Installation selon l'une quelconque des revendications 1 à 7, **caractérisée en ce qu'**elle comprend un plateau de chargement (120) présent au-dessus des plateaux de distribution (1110, 1120, 1130, 1140) de la chambre de préchauffage (110), ledit plateau de chargement étant supporté par des colonnes (1410) traversant les plateaux de distribution.

9. Installation selon la revendication 8, **caractérisée en ce que** le plateau support (120) comporte une pluralité d'ouvertures circulaires (121) chacune destinée à coopérer avec une pile (131) de préformes fibreuses annulaires (130) à densifier.

10. Installation selon l'une quelconque des revendications 1 à 9, **caractérisée en ce qu'**elle comprend un suscepteur comprenant au moins une paroi latérale (101) entourant la chambre de préchauffage (110) et la chambre de réaction (140) et un inducteur (108) apte à chauffer la paroi latérale par induction.

## Patentansprüche

1. Anlage zur thermochemischen Behandlung (100), umfassend eine Reaktionskammer (140), wenigstens einen Gaseinlass (104), eine Gasvorheizkammer (110), die zwischen dem Gaseinlass (104) und der Reaktionskammer (140) gelegen ist, wobei die Vorheizkammer (110) mehrere gelochte Verteilerplatten (111-114), welche beabstandet übereinander gehalten sind, umfasst,
**dadurch gekennzeichnet, dass** die Vorheizkammer (110) ferner zwischen wenigstens zwei einander gegenüberliegenden Verteilerplatten eine Vielzahl von Wänden (1110, 1120, 1130, 1140) umfasst, die zwischen den Platten (111-114) Zirkulationswege für einen Gasstrom definieren, wobei eine jede Wand sich vertikal zwischen den wenigstens zwei einander gegenüberliegenden Verteilerplatten erstreckt.

2. Anlage nach Anspruch 1, **dadurch gekennzeichnet, dass** die Verteilerplatten (111-114) eine Scheibenform aufweisen und dass wenigstens einige Wände (1110, 1120, 1130, 1140) sich zwischen den Platten in einer radialen Richtung erstrecken.

3. Anlage nach Anspruch 1 oder 2, **dadurch gekennzeichnet, dass** wenigstens ein Teil der Wände (2110, 2120, 2130, 2140) eine gewellte Form aufweist.

4. Anlage nach einem der Ansprüche 1 bis 3, **dadurch gekennzeichnet, dass** die Wände (1110, 1120, 1130, 1140) eine Wärmeleitfähigkeit aufweisen, die in einer zu den Verteilerplatten (111-114) parallelen Richtung größer als in einer zu den gelochten Platten senkrechten Richtung ist.

5. Anlage nach Anspruch 4, **dadurch gekennzeichnet, dass** die Wände (1110, 1120, 1130, 1140) aus Verbundwerkstoff mit einer durch eine Matrix verdichteten Faserverstärkung bestehen und dass die Fasern der Verstärkung mehrheitlich in einer zu den Verteilerplatten (111-114) parallelen Richtung ausgerichtet sind.

6. Anlage nach Anspruch 4, **dadurch gekennzeichnet, dass** die Wände (1110, 1120, 1130, 1140) aus Graphit bestehen.

7. Anlage nach einem der Ansprüche 2 bis 6, **dadurch gekennzeichnet, dass** die Anzahl an Wänden (1110, 1120, 1130, 1140) in der Nähe des Umfangs der Verteilerplatten (111-114) größer als in der Mitte der Platten ist.

8. Anlage nach einem der Ansprüche 1 bis 7, **dadurch gekennzeichnet, dass** sie eine Ladeplatte (120), welche oberhalb der Verteilerplatten (1110, 1120, 1130, 1140) der Vorheizkammer (110) vorhanden ist, umfasst, wobei die Ladeplatte durch Säulen (1410), welche die Verteilerplatten durchgreifen, getragen ist.

9. Anlage nach Anspruch 8, **dadurch gekennzeichnet, dass** die Tragplatte (120) eine Vielzahl von kreisförmigen Öffnungen (121) umfasst, die jeweils dazu bestimmt sind, mit einem Stapel (131) von zu verdichtenden ringförmigen Faservorformlingen (130) zusammenzuwirken.

10. Anlage nach einem der Ansprüche 1 bis 9, **dadurch gekennzeichnet, dass** sie einen Suszeptor, der wenigstens eine die Vorheizkammer (110) und die Reaktionskammer (140) umgebende Seitenwand (101) aufweist, sowie einen Induktor (108), der geeignet ist, die Seitenwand durch Induktion zu erwärmen, umfasst.

## Claims

1. A thermochemical treatment installation (100) comprising a reaction chamber (140), at least one gas inlet (104), and a gas preheater chamber (110) situated between the gas inlet (104) and the reaction chamber (140), said preheater chamber (110) having a plurality of perforated distribution trays (111-114) held spaced apart one above another, the installation being **characterized in that** the preheater chamber (110) also includes, between at least two facing distribution trays, a plurality of walls (1110, 1120, 1130, 1140) defining flow paths for a gas stream between said trays (111-114), each wall extending vertically between said at least two facing distribution trays.

2. An installation according to claim 1, **characterized in that** the distribution trays (111-114) are disk-shaped and **in that** at least some of the walls (1110, 1120, 1130, 1140) extend between said trays in a radial direction.

3. An installation according to claim 1 or claim 2, **characterized in that** at least some of the walls (2110, 2120, 2130, 2140) present an undulating shape.

4. An installation according to any one of claims 1 to 3, **characterized in that** the walls (1110, 1120, 1130, 1140) present thermal conductivity that is greater in a direction parallel to the distribution trays (111-114) than in a direction perpendicular to said perforated trays.

5. An installation according to claim 4, **characterized in that** the walls (1110, 1120, 1130, 1140) are made of composite material having fiber reinforcement densified by a matrix, and **in that** the reinforcing fibers extend for the most part in a direction parallel to the distribution trays (111-114).

6. An installation according to claim 4, **characterized in that** the walls (1110, 1120, 1130, 1140) are made of graphite.

7. An installation according to any one of claims 2 to 6, **characterized in that** the number of walls (1110, 1120, 1130, 1140) is greater in the vicinity of the peripheries of the distribution trays (111-114) than in the centers of said trays.

8. An installation according to any one of claims 1 to 7, **characterized in that** it includes a loading tray (120) present above the distribution trays (1110, 1120, 1130, 1140) of the preheater chamber (110), said loading tray being supported by columns (1410) passing through the distribution trays.

9. An installation according to claim 8, **characterized in that** the support tray (120) has a plurality of circular openings (121) each serving to co-operate with a stack (131) of annular fiber preforms (130) for densifying.

10. An installation according to any one of claims 1 to 9, **characterized in that** it includes a susceptor having at least one side wall (101) surrounding the preheater chamber (110) and the reaction chamber (140), and an induction winding (108) suitable for heating the side wall by induction.
